(19) Europäisches Patentamt
European Patent Office
Office européen des brevets

(11) **EP 3 478 046 A1**

(12) **EUROPEAN PATENT APPLICATION**
published in accordance with Art. 153(4) EPC

(43) Date of publication:
**01.05.2019 Bulletin 2019/18**

(51) Int Cl.:
**H05K 9/00** *(2006.01)*  **B32B 15/08** *(2006.01)*
**H01F 1/34** *(2006.01)*

(21) Application number: **17815460.5**

(22) Date of filing: **21.06.2017**

(86) International application number:
**PCT/JP2017/022912**

(87) International publication number:
**WO 2017/221992 (28.12.2017 Gazette 2017/52)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **22.06.2016 JP 2016123493**

(71) Applicant: **Maxell Holdings, Ltd.**
**Kyoto 618-8525 (JP)**

(72) Inventors:
• HIROI,Toshio
  Kyoto, 618-8525 (JP)
• FUJITA, Masao
  Kyoto, 618-8525 (JP)
• TERASAWA ,Makoto
  Kyoto, 618-8525 (JP)

(74) Representative: **Diehl & Partner GbR**
**Patentanwälte**
**Erika-Mann-Strasse 9**
**80636 München (DE)**

(54) **ELECTRIC WAVE ABSORPTION SHEET**

(57) Provided is an electric-wave absorbing sheet that can favorably absorb high frequency electric waves in the millimeter-wave band or higher and that has high handleability. The electric-wave absorbing sheet includes a flexible electric-wave absorbing layer 1 that contains a particulate electric-wave absorbing material 1a and a resin binder 1b. The electric-wave absorbing material is a magnetic iron oxide that magnetically resonates at a frequency band equal to or higher than the millimeter-wave band.

FIG. 1

EP 3 478 046 A1

## Description

Technical Field

The present disclosure relates an electric-wave absorbing sheet that absorbs electric waves, in particular, an electric-wave absorbing sheet that can absorb electric waves with frequencies between several tens of gigahertz (GHz) and several hundreds gigahertz (GHz) (millimeter-wave band) up to three terahertz (THz).

Background Art

Mobile communications such as mobile phones, wireless LAN and electric toll collection system (ETC) utilize electric waves called "centimeter waves" having a frequency band of several gigahertz (GHz).

As electric-wave absorbing sheets for absorbing such centimeter waves, Patent Document 1 proposes a stacked sheet in which a rubber electric-wave absorbing sheet and a paper sheet material (e.g., corrugated paper) are stacked. Patent Document 2 proposes an electric-wave absorbing sheet in which thin sheets containing anisotropic graphite and a binder are stacked alternately in an H-direction and a Y-direction. By adjusting the thickness, the electric-wave absorbing sheet can have stable electric-wave absorbing properties, regardless of the incident direction of electric waves.

Furthermore, in order to absorb electric waves in a still higher frequency band, Patent Document 3 proposes an electric-wave absorbing sheet that can absorb electric waves in the frequency band of 20 GHz or higher, which is obtained by aligning the longitudinal direction of flat soft magnetic particles with the plane direction of the sheet.

Moreover, it is known from Patent Document 4 that an electric-wave absorber that has a packing structure of particles having epsilon iron oxide ($\varepsilon$-$Fe_2O_3$) crystal in the magnetic phase, exhibits electric-wave absorbing performance in a range of 25 to 100 GHz.

Prior Art Documents

Patent Documents

Patent Document 1: JP 2011-233834 A
Patent Document 2: JP 2006-080352 A
Patent Document 3: JP 2015-198163 A
Patent Document 4: JP 2008-060484 A

Disclosure of Invention

Problem to be Solved by the Invention

Recently, in order to increase the capacity of transmission data, wireless communication utilizing a frequency of 60 GHz has been projected, and as vehicle-mounted radar devices utilizing extremely narrow directivity, millimeter-wave radars having frequencies of several tens of GHz or higher (what is called a millimeter-wave band from 30 GHz to 300 GHz) has proceeded. Further, researches on the technologies of utilizing electric waves having frequencies in a terahertz band up to three terahertz (THz) as electric waves in high frequency bands exceeding the millimeter-wave band have proceeded.

However, at present, electric-wave absorbing sheets, which are essential in preventing the leakage of electric waves as one of the technologies utilizing electric waves, can correspond to frequencies from about 20 GHz up to several tens of GHz at a maximum. Electric-wave absorbing sheets that can absorb electric waves in the entire millimeter-wave band between 30 GHz and 300 GHz, or electric waves in a still higher frequency band up to three terahertz (THz) have not yet been realized.

Therefore, it is an object of the present disclosure to solve the above conventional problem, and provide an electric-wave absorbing sheet that can favorably absorb electric waves with frequencies equal to or higher than the millimeter-wave band and that has high handleability.

Means for Solving Problem

An electric-wave absorbing sheet disclosed in the present application, configured to solve the above problem, is an electric-wave absorbing sheet including a flexible electric-wave absorbing layer. The electric-wave absorbing layer contains a particulate electric-wave absorbing material and a resin binder. The electric-wave absorbing material is a magnetic iron oxide that magnetically resonates at a frequency band equal to or higher than a millimeter-wave band.

Effects of the Invention

The electric-wave absorbing layer of the electric-wave absorbing sheet disclosed in the present application includes, as an electric-wave absorbing material, a magnetic iron oxide that magnetically resonates at a high frequency band equal to or higher than the millimeter-wave band. Thereby, electric waves in a high frequency band equal to or higher than several tens of GHz can be converted into heat by magnetic loss. Moreover, since the electric-wave absorbing layer contains a resin binder, it is possible to provide an electric-wave absorbing sheet having flexibility that absorbs electric waves in a high frequency band.

Brief Description of Drawings

FIG. is a cross-sectional view illustrating the configuration of an electric-wave absorbing sheet of this embodiment.
FIG. 2 is a graph illustrating electric-wave absorbing properties of epsilon iron oxide in which part of the Fe site is substituted.
FIG. 3 is a model view illustrating a method for measuring a flexibility characteristic value F of an electric-wave absorbing sheet from a weight applied to the sheet at the time the sheet is bent.
FIG. 4 is a view illustrating impedance matching in the electric-wave absorbing sheet of this embodiment.
FIG. 5 is a model view illustrating a free space method for measuring electric-wave absorbing properties of the electric-wave absorbing sheet.
FIG. 6 is a graph illustrating a relationship between the thickness of an electric-wave absorbing layer of the electric-wave absorbing sheet of this embodiment and electric-wave absorbing properties.
FIG. 7 is a graph indicating simulation results concerning a relationship between permeability and a change in the volume content of an electric-wave absorbing material in the electric-wave absorbing sheet of this embodiment.
FIG. 8 is a view illustrating a magnetic particle model and a resin binder model used in the simulation concerning the relationship between permeability and a change in the volume content of the electric-wave absorbing material.

Description of the Invention

An electric-wave absorbing sheet disclosed in the present application is an electric-wave absorbing sheet including a flexible electric-wave absorbing layer. The electric-wave absorbing layer contains a particulate electric-wave absorbing material and a resin binder. The electric-wave absorbing material is a magnetic iron oxide that magnetically resonates at a frequency band equal to or higher than a millimeter-wave band.

With this configuration, the electric-wave absorbing sheet disclosed in the present application can absorb electric waves in a high frequency band equal to or higher than 30 GHz (millimeter-wave band) by the magnetic resonance of the electric-wave absorbing material. Moreover, a flexible electric-wave absorbing sheet can be obtained using the particulate electric-wave absorbing material and the resin binder. Thus, it is possible to provide an electric-wave absorbing sheet that has high handleability and that can correspond to the future use of higher frequency electric waves, including millimeter-wave radars and communication at high frequencies of several tens of GHz or higher.

In the electric-wave absorbing sheet disclosed in the present application, it is preferred that the electric-wave absorbing layer further contains a dispersant for dispersing the electric-wave absorbing material. Moreover, it is preferred that the dispersant is a phosphate compound. With this configuration, it is possible to favorably disperse fine particulate magnetic iron oxide having an average particle diameter of several tens of nm using the resin binder, and thus provide an electric-wave absorbing sheet with high electric-wave absorbing properties.

It is preferred that the electric-wave absorbing material is epsilon iron oxide. By using, as the electric-wave absorbing material, epsilon iron oxide serving as an electric wave absorber that absorbs electric waves with frequencies higher than 30 GHz, it is possible to provide an electric-wave absorbing sheet that absorbs high frequency electric waves.

In this case, it is preferred that part of a Fe site of the epsilon iron oxide is substituted with a trivalent metal atom. Thus, it is possible to provide an electric-wave absorbing sheet that absorbs electric waves in a desired frequency band by taking advantage of the characteristics of epsilon magnetic iron oxide exhibiting different magnetic resonance frequencies depending on a material substituting for the Fe site.

Further, in the electric-wave absorbing sheet of the present disclosure, it is preferred that a volume content of the magnetic iron oxide in the electric-wave absorbing layer is 30% or more. With this configuration, it is possible to increase a value of a permeability imaginary part ($\mu''$) of the electric-wave absorbing layer, and thus provide an electric-wave absorbing sheet with high electric-wave absorbing properties.

Further, it is preferred that the resin binder contains at least either of a sulfonic group and a carboxyl group, and is halogen free. With this configuration, it is possible to provide an environmentally friendly electric-wave absorbing sheet including a flexible electric-wave absorbing layer.

In the electric-wave absorbing sheet disclosed in the present application, the electric-wave absorbing layer can have a thickness of 1 mm or less.

Further, it is preferred that a reflective layer made of a metal plate, a metal foil or a metal-deposited film, is formed in contact with one surface of the electric-wave absorbing layer. With this configuration, it is possible to provide an electric-wave absorbing sheet that can reliably shield and absorb electric waves in the frequency band of millimeter-waves or higher.

In this case, it is preferred that the reflective layer and the electric-wave absorbing layer are stacked sequentially on a resin base, and an adhesive layer is formed on a surface of the resin base on a side opposite to a side where the electric-wave absorbing layer is disposed. With this configuration, it is possible to provide an electric-wave absorbing sheet having high electric-wave absorbing properties while having excellent handleability, i.e., being easily arranged at a desired place.

Hereinafter, the electric-wave absorbing sheet disclosed in the present application will be described with reference to the drawings.

(Embodiment)

[Sheet Configuration]

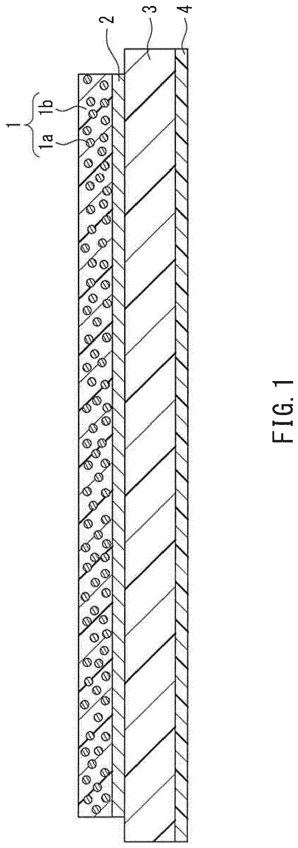

FIG. 1 is a cross-sectional view illustrating the configuration of an electric-wave absorbing sheet of this embodiment.

FIG. 1 is illustrated for the sake of easy understanding of the configuration of the electric-wave absorbing sheet of this embodiment, and does not faithfully reflect the actual sizes or thicknesses of members illustrated therein.

The electric-wave absorbing sheet exemplified in this embodiment includes an electric-wave absorbing layer 1 that contains a particulate electric-wave absorbing material 1a and a resin binder 1b. In the electric-wave absorbing sheet illustrated in FIG. 1, a reflective layer 2 made of a metal material is formed on the back surface side (lower side in FIG. 1) of the electric-wave absorbing layer 1, and a stack of the electric-wave absorbing layer 1 and the reflective layer 2 is disposed on a base film 3 that is a resin base. An adhesive layer 4 is formed on the base film 3 on a side (lower side in FIG. 1) opposite to the side (upper side in FIG. 1) where the electric-wave absorbing layer 1 is disposed.

The electric-wave absorbing sheet of this embodiment is configured so that the electric-wave absorbing material 1a contained in the electric-wave absorbing layer 1 resonates magnetically, thereby converting electric waves (electromagnetic waves) into heat energy by magnetic loss and absorbing electric waves. Thus, the electric-wave absorbing layer 1 can absorb electric waves independently. Therefore, the electric-wave absorbing sheet may be a nonresonant-type (transmission-type) that includes only the electric-wave absorbing layer 1 to absorb electric waves passing therethrough. The electric-wave absorbing sheet of this embodiment also may be a resonant-type (reflection-type) that includes the electric-wave absorbing layer 1 and the reflective layer 2 (metal layer), wherein electric waves are incident upon the electric-wave absorbing layer 1 from one side of the electric-wave absorbing layer 1, and the reflective layer 2 is disposed on the other side of the electric-wave absorbing layer 1, i.e., on the back surface side relative to the electric wave incident side. With this configuration, electric waves incident upon the electric-wave absorbing layer 1 are reliably shielded, while the intensity of electric waves to be emitted as reflected waves can be reduced by the absorption of electric waves by the electric-wave absorbing layer 1.

As described later, in the electric-wave absorbing sheet of this embodiment, impedance matching is performed by adjusting the thickness of the electric-wave absorbing layer 1 based on the frequency of electric waves to be absorbed, thereby allowing electric waves to enter the electric-wave absorbing layer 1 more reliably. For example, in the case of an electric-wave absorbing sheet that absorbs electric waves of 75 GHz, the thickness of a nonresonant-type electric-wave absorbing layer 1 not including a reflective layer will be 3 mm or less, and the thickness of a resonant-type electric-wave absorbing layer 1 including the reflective layer 2 will be 1 mm or less, which are thin. By stacking the base film 3 (resin base) having a predetermined thickness on the electric-wave absorbing layer 1 or the stack of the electric-wave absorbing layer 1 and the reflective layer 2, the handleability of the electric-wave absorbing sheet improves. The base film 3 is not always necessary if the electric-wave absorbing layer 1 alone or the stack of the electric-wave absorbing layer 1 and the reflective layer 2 alone is self-supporting and easy to handle.

Moreover, in many cases, the electric-wave absorbing sheet of this embodiment is attached to the surface of a member located around a generation source of high frequency electric waves. The handleability of the electric-wave absorbing sheet further improves by stacking the adhesive layer 4 on the base film 3. If the base film 3 is not provided, the adhesive layer 4 may be stacked on the electric-wave absorbing layer 1 or the reflective layer 2.

[Electric-Wave Absorbing Material]

In the electric-wave absorbing sheet of this embodiment, the particulate electric-wave absorbing material may be powder of magnetic iron oxide, including epsilon iron oxide magnetic powder, barium ferrite magnetic powder, and strontium ferrite magnetic powder. Among these, epsilon iron oxide is particularly preferred as the electric-wave absorbing material because the electrons of iron atoms precess at high frequencies in spin motion, and epsilon iron oxide has a high effect of absorbing high frequency electric waves of 30 to 300 GHz (millimeter-wave band) or still higher.

Epsilon iron oxide ($\varepsilon$-Fe$_2$O$_3$) is a phase that appears between the alpha phase ($\alpha$-Fe$_2$O$_3$) and the gamma phase ($\gamma$-Fe$_2$O$_3$) in ferric oxide (Fe$_2$O$_3$), and is a magnetic material that can be obtained in a single phase state by a nanoparticle synthesis method combining a reverse micelle method and a sol-gel method.

Epsilon iron oxide, which is a fine particle having an average particle diameter of several nm to several tens of nm, has the largest coercive force among metal oxides of about 20 kOe at room temperature. Moreover, natural magnetic resonance by a gyromagnetic effect based on the precession is caused at a frequency band of several tens of GHz or higher (millimeter-wave band).

In epsilon iron oxide, by substituting part of the Fe site of the crystal with a trivalent metal element such as aluminum (Al), gallium (Ga), rhodium (Rh) or indium (In), it is possible to change a magnetic resonance frequency, i.e., a frequency of electric waves to be absorbed when epsilon iron oxide is used as the electric-wave absorbing material.

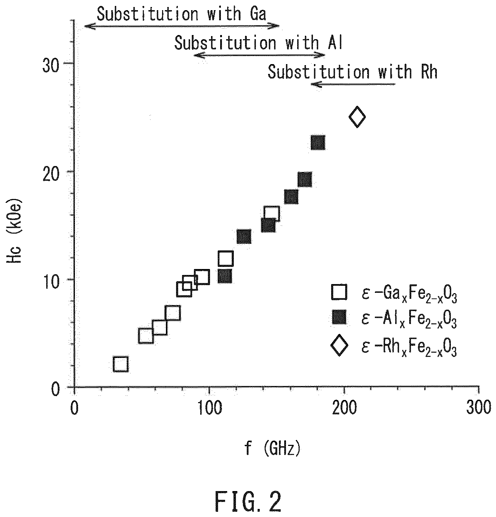

FIG. 2 shows a relationship between a coercive force Hc of epsilon iron oxide and a natural resonance frequency f when the metal element substituting for the Fe site is changed. The natural resonance frequency f coincides with the frequency of electric waves to be absorbed.

FIG. 2 indicates that epsilon iron oxides in which part of the Fe site is substituted have different natural resonance frequencies depending on the type of the substituted metal element and the substitution amount. Moreover, the coercive force of epsilon iron oxide increases in keeping with the natural resonance frequency.

More specifically, epsilon iron oxide substituted with gallium ($\varepsilon$-Ga$_x$Fe$_{2-x}$O$_3$) has an absorption peak in a frequency band from about 30 GHz to 150 GHz by adjusting the substitution amount "x". Epsilon iron oxide substituted with aluminum ($\varepsilon$-Al$_x$Fe$_{2-x}$O$_3$) has an absorption peak in a frequency band from about 100 GHz to 190 GHz by adjusting the substitution amount "x". Therefore, the frequency of electric waves to be absorbed can be set to a desired value by selecting the type of the element substituting for the Fe site of epsilon iron oxide and adjusting the substitution amount of Fe to achieve the natural resonance frequency of the frequency to be absorbed by the electric-wave absorbing sheet. Further, in the case of using epsilon iron oxide substituted with rhodium ($\varepsilon$-Rh$_x$Fe$_{2-x}$O$_3$), it is possible to shift a frequency band of electric waves to be absorbed to a still higher direction of 180 GHz or higher.

Epsilon iron oxides can be purchased, including epsilon iron oxides in which part of the Fe site is substituted with metal. For the formation of the electric-wave absorbing sheets of this embodiment, $\varepsilon$-Al$_x$Fe$_{2-x}$O$_3$ particles were obtained that have an average particle diameter of about 30 nm and that have a substantially spherical shape or short rod shape (bar shape), as the electric-wave absorbing material 1a.

[Electric-Wave Absorbing Layer (Binder)]

The resin binder 1b to be used in the electric-wave absorbing layer 1 may be a resin material such as epoxy-based resin, polyester-based resin, polyurethane-based resin, acrylic-based resin, phenol-based resin, melamine-based resin, or rubber-based resin.

Specifically, the epoxy-based resin may be a compound obtained by epoxidizing hydroxyl groups at both terminals of bisphenol A. The polyester-based resin may be, e.g., polyethylene terephthalate, polytrimethylene terephthalate, polybutylene terephthalate, polyethylene naphthalate, or polybutylene naphthalate.

The polyurethane-based resin may be, e.g., polyester-based urethane resin, polyether-based urethane resin, polycarbonate-based urethane resin, or epoxy-based urethane resin. The acrylic-based resin may be a functional group-containing methacrylic polymer that is obtained by copolymerizing: alkyl acrylate and/or alkyl methacrylate that is methacrylic-based resin and that has 2 to 18 carbon atoms in the alkyl group; a functional group-containing monomer; and as needed other modifying monomers copolymerizable therewith.

The rubber-based resin to be used as the binder may be, e.g., a rubber-based material such as SIS (styrene-isoprene block copolymer) or SBS (styrene-butadiene block copolymer) which is a styrene-based thermoplastic elastomer, EPDM (ethylene-propylene-diene-rubber) which is a petroleum synthetic rubber, acrylic rubber, or silicone rubber.

From the viewpoint of environment, the resin to be used as the binder preferably does not contain halogen, i.e., halogen free. These resin materials are used in general as binder materials for resin sheets, and can be obtained easily.

Since the electric-wave absorbing layer 1 of the electric-wave absorbing sheet of this embodiment is made up of the electric wave absorber 1a (particulate magnetic iron oxide) and the resin binder 1b, it can be a flexible sheet. The expressions "flexible" and "flexibility" in this specification refer to a state in which the electric-wave absorbing layer 1 can be bent to a certain degree. For example, in the case of using an electric-wave absorbing layer having a thickness of several hundred μm that contains polyesterurethane resin "VYLON UR 8700" (trade name, VYLON is a registered trademark) manufactured by TOYOBO CO., LTD., as the binder, when the sheet is rolled up cylindrically with a diameter of about several mm to ten mm and thereafter the bent state is released, plastic deformation such as breakage does not occur, and the sheet returns to a flat state.

[Electric-Wave Absorbing Layer (Dispersant)]

The electric-wave absorbing layer 1 of the electric-wave absorbing sheet of this embodiment contains epsilon iron oxide as the electric-wave absorbing material 1a. Since epsilon iron oxide is a fine nanoparticle having an average particle diameter of several nm to several tens of nm as described above, it is important to favorably disperse the nanoparticles in the binder 1b during the formation of the electric-wave absorbing layer 1.

Therefore, in the electric-wave absorbing sheet of this embodiment, the electric-wave absorbing layer 1 preferably contains a dispersant.

As the dispersant, compounds having a polar group such as a phosphate group, a sulfonic group, a carboxy group or the like can be used. Among these, the dispersant is preferably a phosphate compound that has a phosphate group in its molecule.

Examples of the phosphate compound include: arylsulfonic acids such as phenylphosphonic acid and phenylphosphonic dichloride; alkylphosphonic acids such as methylphosphonic acid, ethylphosphonic acid, octylphosphonic acid, propylphosphonic acid; and polyfunctional phosphonic acids such as hydroxyethanediphosphonic acid, nitrotris methylene phosphonic acid. These phosphate compounds are flame-retardant and function as dispersants for fine magnetic iron oxide powder, thereby favorably dispersing epsilon iron oxide particles in the binder.

Specifically, as the dispersant, phenylphosphonic acid (PPA) manufactured by FUJIFILM Wako Pure Chemical Corporation or Nissan Chemical Corporation and an oxidized phosphoric acid ester "JP-502" (trade name) manufactured by JOHOKU CHEMICAL CO., LTD., can be used.

In one example, the composition of the electric-wave absorbing layer 1 may be 2 to 50 parts (parts by mass) of the resin binder and 0.1 to 15 parts of the phosphate compound based on 100 parts of epsilon iron oxide powder. When the content of the resin binder is less than 2 parts, magnetic iron oxide cannot be dispersed favorably, and the shape of the electric-wave absorbing sheet cannot be maintained. When the content of the resin binder exceeds 50 parts, the volume content of the magnetic iron oxide in the electric-wave absorbing sheet is lowered and the permeability decreases, which lessens the electric-wave absorption effects.

When the content of the phosphate compound is less than 0.1 parts, magnetic iron oxide cannot be dispersed favorably using the resin binder. When the content of the phosphate compound exceeds 15 parts, the effect of favorably dispersing magnetic iron oxide becomes saturated. The volume content of the magnetic iron oxide in the electric-wave absorbing sheet is lowered and the permeability decreases, which lessens the electric-wave absorption effects.

In addition to the phosphate compounds described above, examples of the dispersant to be contained in the electric-wave absorbing layer of the electric-wave absorbing sheet of this embodiment include: fatty acids having 12 to 18 carbon atoms [RCOOH (R is an alkyl group or alkenyl group having 11 to 17 carbon atoms)] such as caprylic acid, capric acid, lauric acid, myristic acid, palmitic acid, stearic acid, behenic acid, oleic acid, elaidic acid, linoleic acid, linolenic acid, and stearolic acid; metal soaps made of alkali metal or alkaline earth metal of the fatty acids; compounds containing fluorine of the fatty acid esters; amides of the fatty acids such as polyalkylene oxide alkyl phosphate ester, lecithin, trialkyl polyolefin oxy quaternary ammonium salt (alkyl has 1 to 5 carbon atoms, olefin is ethylene, propylene, etc.); and copper phthalocyanine. Moreover, the dispersant may be a silane coupling agent. These dispersants may be used alone or in combination.

In the electric-wave absorbing sheet of this embodiment, by adding the dispersant to the electric-wave absorbing layer 1, it is possible to improve the wettability of the surface of the electric-wave absorbing material 1a and control the adsorption of the resin binder 1b to the surface of the electric-wave absorbing material 1a. As a result, even when epsilon iron oxide magnetic powder, which is a fine particle having an average particle diameter of several nm to several tens of nm, is used as the electric-wave absorbing material, it can be dispersed uniformly. Thereby, an electric-wave absorbing sheet with flexibility can be formed.

Here, the electric-wave absorbing layer to be used in the electric-wave absorbing sheet of this embodiment was measured for a change in flexibility depending on with or without the dispersant and the type of the dispersant to be contained. The degree of flexibility was evaluated based on a flexibility evaluation value F described below.

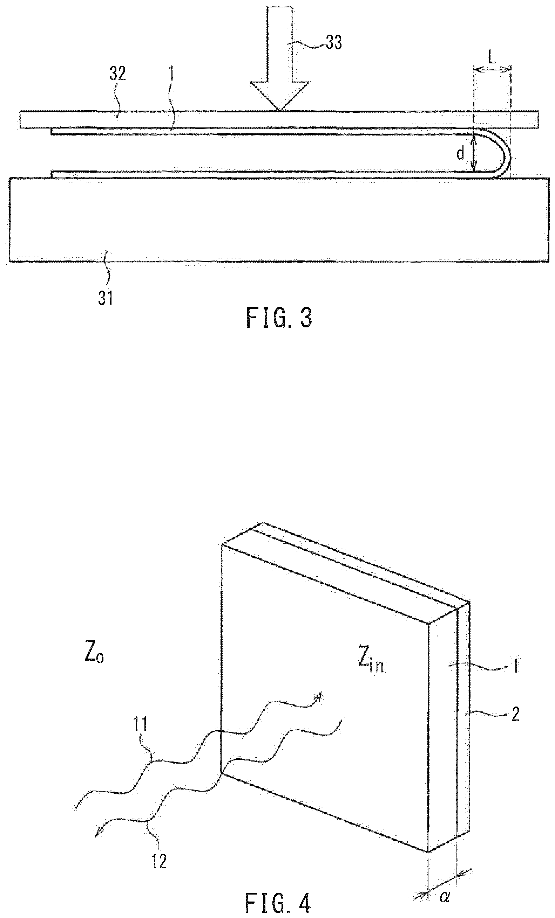

FIG. 3 is a view illustrating a state of measuring the flexibility evaluation value F of the electric-wave absorbing sheet that determines the degree of flexibility of the electric-wave absorbing sheet of this embodiment.

A ribbon-like electric-wave absorbing sheet having a length of 100 mm and a width of 20 mm is used for the measurement. In this measurement, considering the application to a nonresonant-type electric-wave absorbing sheet not including a reflective layer, the flexibility of the electric-wave absorbing layer alone is evaluated. As illustrated in FIG.

3, the ribbon-like electric-wave absorbing layer is bent in the middle (center) in the longitudinal direction of the electric-wave absorbing layer so that the both ends in the length direction overlap with each other, and an external force for maintaining this state is measured. Further, by dividing the obtained external force by a cross-sectional area of the electric-wave absorbing layer, it is possible to obtain a flexibility evaluation value F of the electromagnetic-wave absorbing sheet to be measured.

For example, as illustrated in FIG. 3, an electric-wave absorbing layer to be measured is placed on a measurement stand 31 of an electronic balance, and a self-weight of the electric-wave absorbing layer 1 in a state where no external force is applied is measured. Then, a weight applied to the electronic balance in a state where the electric-wave absorbing layer is deformed by application of an external force is measured. The self weight of the electric-wave absorbing layer 1 is subtracted from the obtained measurement result to find out a weight necessary to maintain the bent state of the electric-wave absorbing sheet (electric-wave absorbing layer).

A plate member 32 as illustrated in FIG. 3 is placed on the upper side of the electric-wave absorbing layer 1 so as to maintain a predetermined bent state of the electric-wave absorbing layer 1, and an external force indicated by a white arrow 33 in FIG. 3 is applied to the plate member 32 vertically downward. At this time, at a position where a distance L from an outer end in the bent portion of the electric-wave absorbing layer 1 is 10 mm, an external force 33 is measured as a weight when a space d between the inner surfaces of the bent electric-wave absorbing layer 1 is 10 mm and 20 mm. A value obtained by dividing this external force by a cross-sectional area D (unit: $mm^2$) of the electric-wave absorbing layer 1 is determined as a flexibility evaluation value F ($g/mm^2$).

For example, if the electronic balance indicates that the external force 33 applied to an electric-wave absorbing layer (thickness: 100 $\mu$m (= 0.1 mm)) when the layer is turned into the state as illustrated in FIG. 3 is 6 g in weight, and the cross-sectional area D of the electric-wave absorbing layer 1 is 20 (mm) x 0.1 (mm) = 2 ($mm^2$), the flexibility evaluation value F is $6 \div 2 = 3$ $g/mm^2$. It can be said that, when the flexibility evaluation value F is greater than 0 and 5 or less, the electric-wave absorbing sheet has favorable flexibility. When the value is in a range from 1.0 or more and 3.5 or less, the electric-wave absorbing sheet has further favorable properties from the viewpoint that the sheet has both of the self-supporting properties and flexibility.

The reason why the flexibility evaluation value F is set greater than 0 is described below. An electric-wave absorbing sheet of F = 0 is in a state where the sheet is bent only by its own weight, and cannot form a shape like FIG. 3, where portions from the bent portion toward the both ends are maintained in parallel. The electric-wave absorbing sheet of F = 0 is too soft and not self-supporting, and difficult to handle when a user carries it or attaches it to a predetermined place. On the other hand, an electric-wave absorbing sheet exceeding F = 5 requires a large force for bending, which impairs workability.

In the measurement of the flexibility evaluation value F illustrated in FIG. 3, it is premised that the electric-wave absorbing sheet to be measured is in an elastic deformation region. In other words, it is important for the electric-wave absorbing sheet to return to the initial shape when the plate member 32 placed on the sheet is removed after the measurement of the flexibility evaluation value F. If plastic deformation occurs due to the applied external force and the sheet cannot return to the initial shape after removal of the plate member 32, or an appearance abnormality such as cracks occurs in the outer side of the bent portion of the sheet, the electric-wave absorbing sheet is judged as not having a predetermined flexibility evaluation value.

Three kinds of electric-wave absorbing layers below were prepared for the measurement of the flexibility evaluation value F.

[Example 1]

| | | |
|---|---|---|
| Magnetic iron oxide powder | Epsilon iron oxide magnetic powder | 100 parts |
| Resin binder | Polyurethane | 29 parts |
| Dispersant | Phenylphosphonic acid (PPA) | 3 parts |
| Solvent | Methyl ethyl ketone (MEK) | 71 parts |

[Example 2]

| | | |
|---|---|---|
| Magnetic iron oxide powder | Epsilon iron oxide magnetic powder | 100 parts |
| Resin binder | Polyurethane | 29 parts |

(continued)

| Dispersant | Stearic acid (SA) | 3 parts |
| Solvent | Methyl ethyl ketone (MEK) | 71 parts |

[Example 3]

| Magnetic iron oxide powder | Epsilon iron oxide magnetic powder | 100 parts |
| Resin binder | Polyurethane | 29 parts |
| Solvent | Methyl ethyl ketone (MEK) | 70 parts |

In all the examples, the resin binder used was polyesterurethane resin "VYLON UR 8700" (trade name, VYLON is a registered trademark) manufactured by TOYOBO CO., LTD., and the average particle diameter of epsilon iron oxide was 30 nm.

Table 1 indicates the measurement results of the flexibility evaluation values F.

[Table 1]

| d (mm) | Example 1 | Example 2 | Example 3 |
| --- | --- | --- | --- |
| 20 | 0.9 | 1.0 | 3.2 |
| 10 | 4.2 | 4.8 | - |

As indicated in Table 1, the electric-wave absorbing layer of Example 1 containing phenylphosphonic acid as a dispersant and the electric-wave absorbing layer of Example 2 containing stearic acid as a dispersant both had smaller flexibility evaluation values F than the electric-wave absorbing layer of Example 3 not containing a dispersant, and thus had higher flexibility.

When the space d between the inner surfaces of the bent electric-wave absorbing layer was 20 mm, the flexibility evaluation values F of the electric-wave absorbing layers, including the electric-wave absorbing layer of Example 3 not containing a dispersant, were within the range of 1 to 3.5, and therefore, all the electric-wave absorbing layers can be evaluated as layers having flexibility and favorable self-supporting properties.

Meanwhile, in the electric-wave absorbing layer of Example 3 not containing a dispersant, plastic deformation occurred in the bent portion when the measurement of d = 10 mm, where the space d between the inner surfaces of the electric-wave absorbing layer is set at 10 mm, was attempted to be performed, and the flexibility evaluation value F could not be measured. In the actual use of the electric-wave absorbing sheet, when the electric-wave absorbing sheet is attached to a predetermined position and peeled off for reattachment for example, there is a possibility that the electric-wave absorbing sheet is strongly bent and is in the same condition as the case of d = 10 mm. If the electric-wave absorbing sheet is expected to be bent strongly as described above, it is preferred that a dispersant is added to the electric-wave absorbing layer to produce an electric-wave absorbing sheet having more favorable flexibility.

[Method for Producing Electric-Wave Absorbing Layer]

Hereinafter, a method for producing the electric-wave absorbing layer 1 of the electric-wave absorbing sheet of this embodiment will be described. The electric-wave absorbing layer 1 of the electric-wave absorbing sheet of this embodiment is formed by preparing a magnetic coating material that contains at least magnetic iron oxide powder and a resin binder, and applying the magnetic coating material in a predetermined thickness, followed by drying and calendering.

First, the magnetic coating material is prepared.

The magnetic coating material is prepared by obtaining a kneaded mixture of epsilon iron oxide powder, a phosphate compound (dispersant) and a resin binder, and diluting the kneaded mixture, followed by dispersion and filtration with a filter. In one example, the kneaded mixture can be obtained by mixing and kneading the materials with a pressurized batch-type kneader. In one example, the dispersion of the kneaded mixture can be obtained as a dispersion liquid using a sand mill filled with beads such as zirconia. At this time, a crosslinking agent can be blended as needed.

The magnetic coating material thus obtained is applied to a peelable support using a table coater, a bar coater, or the like. In one example, the peelable support is a 38 $\mu$m-thick polyethylene terephthalate (PET) sheet that has been subjected to a peeling treatment by silicone coating.

The magnetic coating material in a wet state is then dried at 80°C and calendered at a predetermined temperature using a calender to form an electric-wave absorbing layer on the support.

In one example, the magnetic coating material in a wet state applied in a thickness of 1 mm on the support resulted in an electric-wave absorbing layer having a thickness of 400 $\mu$m after drying and 300 $\mu$m after calendering.

In this manner, the electric-wave absorbing layer 1 in which nano-order fine epsilon iron oxide as the electric-wave absorbing material 1a was dispersed favorably in the resin binder 1b was produced.

Another method for preparing the magnetic coating material may include mixing at high speed at least magnetic iron oxide powder, a phosphate compound (dispersant) and a resin binder as magnetic coating material components with a high-speed stirrer to prepare a mixture, and dispersing the obtained mixture with a sand mill.

In this production method, in some cases, the dispersant is not uniformly adsorbed on the surface of the magnetic iron oxide powder in the magnetic coating material to be obtained, and the degree of dispersion of the electric-wave absorbing material 1a in the electric-wave absorbing layer 1 after drying and calendering is inferior to the case of obtaining the kneaded mixture of magnetic iron oxide powder described above. However, where an electric-wave absorbing layer to be obtained can exhibit predetermined electric-wave absorbing properties by adjusting the kind, size, shape, and other conditions of magnetic iron oxide as the electric-wave absorbing material, adopting such an easy production method is advantageous in terms of forming the electric-wave absorbing layer more simply.

Moreover, where the average particle diameter of the magnetic iron oxide power as the electric-wave absorbing material is not very small, the electric-wave absorbing layer can be formed without using a phosphate compound as the dispersant.

In the electric-wave absorbing sheet of this embodiment, the thickness of the electric-wave absorbing layer largely affects electric-wave absorbing properties. The thickness of the electric-wave absorbing layer will be detailed later.

[Reflective Layer]

The electric-wave absorbing sheet of this embodiment includes the reflective layer 2 on the back surface side of the electric-wave absorbing layer 1 as illustrated in FIG. 1.

Any metal layer that is formed in close contact with the back surface of the electric-wave absorbing layer 1 (the surface thereof on the lower side in FIG. 1) may be used as the reflective layer 2. Specifically, the reflective layer 2 may be a metal plate disposed in close contact with the back surface side of the electric-wave absorbing layer 1, or a metal foil disposed in close contact with the back surface side of the electric-wave absorbing layer 1. Further, the reflective layer 2 may be a metal-deposited film formed on the back surface of the electric-wave absorbing layer 1, or a metal-deposited film formed on a surface, on the electric-wave absorbing layer 1 side, of a nonmetal sheet or a plate-like member that is disposed on the back surface side of the electric-wave absorbing layer 1.

The kind of the metal constituting the reflective layer 2 is not particularly limited, and various kinds of metal materials, including metal materials generally used for electronic components such as aluminum, copper and chromium can be used. It is more preferable to use metal with a minimum electrical resistance and a high corrosion resistance.

In the electric-wave absorbing sheet of this embodiment, the reflective layer 2 provided on the back surface of the electric-wave absorbing layer 1 can reliably avoid penetration of electric waves through the electric-wave absorbing sheet. Thus, it is possible to provide an electric-wave absorbing sheet that prevents the leakage of electric waves to be emitted to the outside from electric circuit components driven at high frequencies.

Other than the usage for reliably preventing the transmission of electric waves by forming the reflective layer 2 on the back surface of the electric-wave absorbing layer 1, the electric-wave absorbing sheet can be used also as, e.g., an isolator that is designed to attenuate electric waves while allowing penetration of part of electric waves. Including these usages, it is not essential to provide the reflective layer 2 made of a metal film on the back surface side of the electric-wave absorbing layer 1 in the electric-wave absorbing sheet of this embodiment. As described above, the electric-wave absorbing sheet may be a resonant type electric-wave absorbing sheet including the reflective layer 2 on the back surface side of the electric-wave absorbing layer 1, or a nonresonant type electric-wave absorbing sheet not including a reflective layer on the back surface side of the electric-wave absorbing sheet.

[Base Film, Adhesive Layer]

In the electric-wave absorbing sheet of this embodiment, the stack of the electric-wave absorbing layer 1 and the reflective layer 2 is formed on the base film 3 as illustrated in FIG. 1.

As described above, it is possible to impart higher electric-wave absorbing properties to the electric-wave absorbing sheet of this embodiment by adjusting the thickness of the electric-wave absorbing layer 1. Because of this, in some cases, the thickness of the electric-wave absorbing layer 1 cannot be determined only from the viewpoint of strength and handleability as the electric-wave absorbing sheet. If an electric-wave absorbing sheet in which the reflective layer 2 is stacked on the electric-wave absorbing layer 1 does not have enough thickness as a whole and cannot have a predetermined strength, or does not have sufficient self-supporting properties, it is preferable to stack the base film 3 (resin base) on the back surface side of the reflective layer 2 as illustrated in FIG. 1.

The base film 3 may be formed using various resin films such as a PET film, rubbers, and paper materials such as Japanese paper. The electric-wave absorbing properties in the electric-wave absorbing sheet of this embodiment are not affected by the material or thickness of the base film 3. Thus, it is possible to select a base film 3 made from an appropriate material and having an appropriate thickness, from the viewpoint of the practical use of the electric-wave absorbing sheet.

Moreover, the electric-wave absorbing sheet of this embodiment illustrated in FIG. 1 includes the adhesive layer 4 on the surface of the base film 3 on a side opposite to a side where the electric-wave absorbing layer 1 is formed.

By providing the adhesive layer 4, it is possible to attach the stack of the reflective layer 2 and the electric-wave absorbing layer 1 disposed on the base film 3 to a desired position, including an inner surface of a housing that contains an electric circuit and an inner surface or outer surface of an electric device. Specifically, since the electric-wave absorbing layer 1 of the electric-wave absorbing sheet of this embodiment has flexibility, it can be attached easily even on a curved surface (bent surface). Thus, the adhesive layer 4 improves the handleability of the electric-wave absorbing sheet.

The adhesive layer 4 may be formed using a known material utilized as an adhesive layer such as an adhesive tape, including an acrylic-based adhesive, a rubber-based adhesive, and a silicone-based adhesive. A tackifier or crosslinking agent may be used to adjust the tackiness with respect to an adherend and to reduce adhesive residues. The tackiness with respect to an adherend is preferably 5 N/10 mm to 12 N/10 mm. When the tackiness is less than 5 N/10 mm, the electric-wave absorbing sheet may be easily peeled off from an adherend or displaced. When the tackiness is larger than 12 N/10 mm, the electric-wave absorbing sheet is difficult to be peeled off from an adherend.

The thickness of the adhesive layer is preferably 20 $\mu$m to 100 $\mu$m. When the adhesive layer is thinner than 20 $\mu$m, the tackiness is low and the electric-wave absorbing sheet may be easily peeled off from an adherend or displaced. When the adhesive layer is thicker than 100 $\mu$m, the electric-wave absorbing sheet is difficult to be peeled off from an adherend. If cohesion of the adhesive layer is low, an adhesive may remain on an adherend when the electric-wave absorbing sheet is peeled off from the adherend.

The adhesive layer in the present specification may be an adhesive layer for unpeelable attachment, or an adhesive layer for peelable attachment.

Needless to say, it is not essential for the electric-wave absorbing sheet to include the adhesive layer 4 for attachment of the electric-wave absorbing sheet to a predetermined surface. Instead, the surface of a member on which the electric-wave absorbing sheet is to be disposed may have tackiness, or a double-sided tape or an adhesive may be used to attach the electric-wave absorbing sheet to a predetermined part. It is apparent from the above that the adhesive layer 4 is not an essential component in the electric-wave absorbing sheet of this embodiment.

Moreover, although the electric-wave absorbing sheet of this embodiment may be a sheet made up of the electric-wave absorbing layer 1 alone or a sheet made up of the stack of the electric-wave absorbing layer 1 and the reflective layer 2, an adhesive layer may be provided in these electric-wave absorbing sheets.

[Impedance Matching]

In the electric-wave absorbing sheet of this embodiment, it is important to match the input impedance of the electric-wave absorbing layer to the impedance in the air (vacuum) in order to more reliably absorb incident electric waves.

FIG. 4 is a view illustrating impedance matching of the electric-wave absorbing layer.

FIG. 4 illustrates an electric-wave absorbing sheet that includes the reflective layer 2 on the back surface of the electric-wave absorbing layer 1. Such an electric-wave absorbing sheet configured to include the reflective layer 2 on the back surface enables easy measurement because electric waves that are not absorbed by the electric-wave absorbing layer 1 are reflected and emitted to the front side (electric wave incident side). In the consideration of impedance matching, it is sufficient to take into account only the electric-wave absorbing layer 1, and the reflective layer 2 is not an essential configuration. Further, although the electric-wave absorbing sheet of this embodiment includes the base film 3 and the adhesive layer 4 on the back surface side of the reflective layer 2 as illustrated in FIG. 1, the base film 3 and the adhesive layer 4 are irrelevant in the consideration of impedance matching and thus are not illustrated in FIG. 4.

As illustrated in FIG. 4, electric waves 11 to be absorbed by the electric-wave absorbing sheet propagate through the air and enter the electric-wave absorbing layer 1 vertically. Electric waves incident upon the electric-wave absorbing layer 1 are absorbed by the magnetic resonance of epsilon iron oxide, which is the electric-wave absorbing material in the electric-wave absorbing layer. The base film 3 is not illustrated in FIG. 4, and electric waves greatly attenuated are reflected by the reflective layer 2 on the back surface and emitted forward as reflected waves 12. By measuring the intensity of the reflected waves 12 and comparing the measured intensity with the intensity of the incident electric waves 11, it is possible to comprehend the degree of electric-wave absorption in the electric-wave absorbing sheet.

Here, an impedance $Z_{in}$ of the electric-wave absorbing layer 1 of the electric-wave absorbing sheet is expressed by Formula (1) below.
[Numerical Formula 1]

$$Z_{in} = Z_o \sqrt{\frac{\mu_r}{\varepsilon_r}} \tanh\left(\iota \frac{2\pi d}{\lambda} \sqrt{\varepsilon_r \mu_r}\right) \qquad (1)$$

In Formula (1) above, $\mu_r$ is a complex permeability of the electric-wave absorbing layer 1, $\varepsilon_r$ is a complex permittivity of the electric-wave absorbing layer 1, $\lambda$ is a wavelength of incident electric waves, and d is a thickness of the electric-wave absorbing layer 1.

Here, $Z_0$ is an impedance value in a vacuum state and is about 377 $\Omega$, which is almost equal to the impedance in the air. By making $Z_{in}$ equal to $Z_0$, the impedance between in the air and the electric-wave absorbing layer 1 is matched, so that electric waves propagating through the air can enter the electric-wave absorbing layer 1 directly without being reflected or scattered on the surface of the electric-wave absorbing layer 1 of the electric-wave absorbing sheet. Thus, by performing impedance matching of the electric-wave absorbing layer 1 in order to reduce reflection of electric waves on the surface of the electric-wave absorbing layer 1 to make electric waves directly enter the electric-wave absorbing layer 1, it is possible to maximize electric-wave absorbing properties possessed by the electric-wave absorbing layer 1.

It is understood that in order to make $Z_{in}$ equal to $Z_0$ in Formula (1) above, if the wavelength $\lambda$ of electric waves is determined, the thickness d of the electric-wave absorbing layer 1 can be set to a predetermined value. In other words, when the frequency of electric waves to be absorbed by the electric-wave absorbing layer 1 is determined, an optimum thickness d as the electric-wave absorbing layer 1 can be determined.

The above was demonstrated in accordance with a free space method using actually produced electric-wave absorbing sheets.

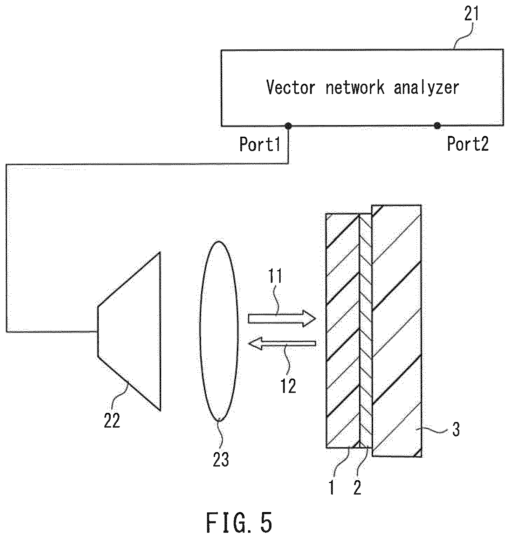

FIG. 5 schematically illustrates a measurement state based on the free space method.

An electric-wave absorbing sheet used in the measurement includes a square electric-wave absorbing layer (one side: 120 mm). The electric-wave absorbing layer was prepared using epsilon iron oxide having an average particle diameter of 30 nm (electric-wave absorbing material), "VYLON UR 8700" (trade name) manufactured by TOYOBO CO., LTD. (binder), and PPA manufactured by Nissan Chemical Corporation (dispersant). The electric-wave absorbing layer was fixed by being sandwiched between an aluminum plate having a thickness of 5 mm disposed on the back side and an aluminum plate with an opening 100 mm in diameter disposed on the front side.

A vector network analyzer MS4647 Bbor (ME7838A) 21 manufactured by ANRITSU CORPORATION was used in the measurement. One port of the analyzer was used to vertically irradiate the electric-wave absorbing sheet with input waves 11 (millimeter-waves) having a predetermined frequency, from a transmitting and receiving antenna 22 via a dielectric lens 23. By measuring the reflected waves 12 from the electric-wave absorbing sheet and comparing the intensity of the input waves 11 with the intensity of the reflected waves 12, a reflection attenuation rate RL (Return Loss), which is a degree of attenuation, was determined in dB.

RL was calculated by Formula (2) below.
[Numerical Formula 2]

$$\mathrm{RL} = 20\log_{10}\left|\frac{Z_{in} - Z_o}{Z_{in} + Z_o}\right| \qquad (2)$$

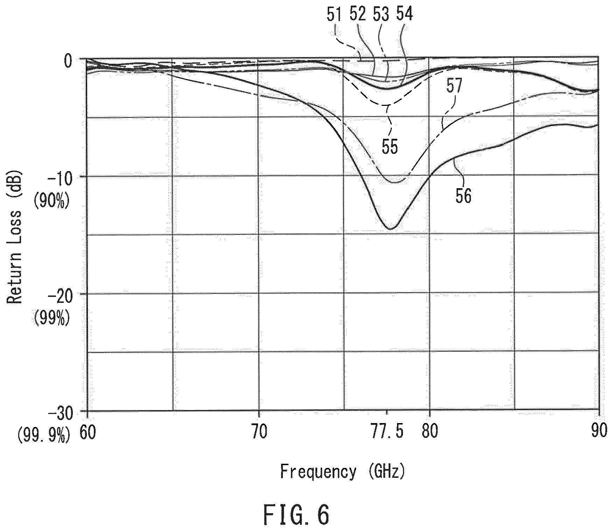

FIG. 6 is a graph illustrating the degrees of attenuation in reflected waves from electric-wave absorbing layers having different thicknesses.

In FIG. 6, a reference numeral 51 denotes RL of an electric-wave absorbing layer having a thickness d of 50 $\mu$m, a reference numeral 52 denotes RL of an electric-wave absorbing layer having a thickness d of 196 $\mu$m, a reference numeral 53 denotes RL of an electric-wave absorbing layer having a thickness d of 251 $\mu$m, a reference numeral 54 denotes RL of an electric-wave absorbing layer having a thickness d of 326 $\mu$m, a reference numeral 55 denotes RL of an electric-wave absorbing layer having a thickness d of 404 $\mu$m, a reference numeral 56 denotes RL of an electric-wave absorbing layer having a thickness d of 519 $\mu$m, and a reference numeral 57 denotes RL of an electric-wave absorbing layer having a thickness d of 603 $\mu$m.

As is clear from the result of FIG. 6, all of the above cases resulted in the largest reflection attenuation amount RL when the frequency was 77.5 GHz. It is confirmed that there is no difference in the frequency of electric waves to be absorbed depending on the thickness d of the electric-wave absorbing layers. The above is a natural result because the electric-wave absorbing sheets of this embodiment utilize the electric-wave absorption by the magnetic resonance of epsilon iron oxide used as the electric-wave absorbing material 1a.

With regard to the thickness d of the electric-wave absorbing layer, the RL of electric waves increases as the thickness d increases. However, the thickness d = 519 $\mu$m denoted by the reference numeral 56 resulted in the largest RL (RL = -15dB) and the largest electric-wave absorption, and a still greater thickness d = 603 $\mu$m denoted by the reference numeral 57 resulted in a smaller RL (RL = -11dB). This indicates that in the electric-wave absorbing layers used in the experiment, when the thickness d was around 520 $\mu$m, $Z_{in}$ was almost equal to $Z_0$ and impedance was matched, so that maximum electric-wave absorbing properties were exhibited as an electric-wave absorbing layer.

Matching of impedance around the thickness d of 520 $\mu$m was also confirmed by simulations performed separately.

As described above, in the electric-wave absorbing sheet described in this embodiment, by selecting the thickness d of the electric-wave absorbing layer in accordance with the frequency of electric waves to be absorbed in order to match the input impedance $Z_{in}$ to the impedance $Z_0$ of the air, higher electric-wave absorbing properties can be obtained. Specifically, when the input impedance ($Z_{in}$) of the electric-wave absorbing layer is not matched to the impedance ($Z_0$) in the air, many electric waves are reflected on the surface of the electric-wave absorbing layer and cannot enter the electric-wave absorbing layer. Hence, even if the electric-wave absorbing layer is formed using epsilon iron oxide having high electric-wave absorption efficiency, the effect cannot be fully exhibited. In other words, when the electric-wave absorbing layer has an absorptance of 90% or more, i.e., the reflection attenuation rate RL is larger than -15 dB, impedance is matched.

Next, the present inventors studied the conditions for obtaining still higher electric-wave absorbing properties in the electric-wave absorbing sheet of this embodiment.

In the electric-wave absorbing sheet of this embodiment, since electric waves are absorbed by the magnetic resonance of the electric-wave absorbing material of the electric-wave absorbing layer, the properties of absorbing electric waves improve as the permeability of the electric-wave absorbing layer increases. Here, the permeability of the electric-wave absorbing material is determined by its material. Since the electric-wave absorbing layer is made up of the electric-wave absorbing material and the resin binder, the permeability of the electric-wave absorbing layer changes when the content of the electric-wave absorbing material in the electric-wave absorbing layer changes, which affects electric-wave absorbing properties. In other words, the permeability of the electric-wave absorbing layer increases as the volume content of the electric-wave absorbing material in the electric-wave absorbing layer increases, and thus the electric-wave absorbing layer can absorb electric waves more efficiently.

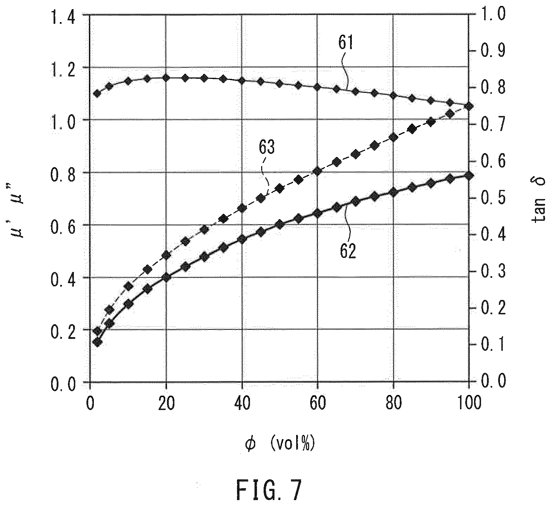

FIG. 7 is a graph illustrating a change in a permeability real part $\mu'$ (reference numeral 61) and a change in a permeability imaginary part $\mu''$ (reference numeral 62) according to a change in the volume content of magnetic iron oxide powder in the electric-wave absorbing layer, and a change in a tan $\delta$ (reference numeral 63) that is an angle formed by the permeability real part $\mu'$ and the permeability imaginary part $\mu''$. FIG. 7 indicates simulation results in the case of using epsilon iron oxide as the electric-wave absorbing material.

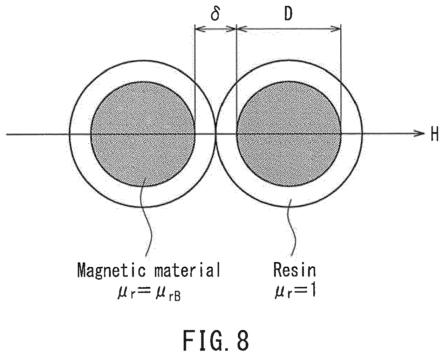

FIG. 8 illustrates a simulation model, the results of which are indicated in FIG. 7.

In the simulation, calculations were carried out on the assumption that, as illustrated in FIG. 7, a particulate magnetic material and a resin binder have a configuration in which magnetic powder (permeability $\mu_r = \mu_{rB}$) having a diameter of D is surrounded by a resin layer (permeability $\mu_r = 1$) having a thickness of $\delta/2$.

The permeability $\mu_r$ of the electric-wave absorbing layer as a whole can be expressed by Formula (3) below.
[Numerical Formulae 3]

$$\mu_r = \frac{\mu_{rB}\left(1 + \frac{\delta}{D}\right)}{1 + \mu_{rB}\frac{\delta}{D}} \qquad (3)$$

$$\Phi = \left(\frac{D}{\delta + D}\right)^3 \qquad (4)$$

$$\mu_r = \frac{\mu_{rB}}{(1 - \mu_{rB})\Phi^{\frac{1}{3}} + \mu_{rB}} \qquad (5)$$

From the model illustrated in FIG. 8, the volume content of the magnetic powder in the electric-wave absorbing layer can be expressed as Formula (4) above from a relationship between the diameter D and $\delta$.

Formula (5) can be derived from Formula (3) and Formula (4). The permeability real part $\mu'$ and the permeability imaginary part $\mu''$ are calculated using Formula (5). The results are illustrated in FIG. 7.

As illustrated in FIG. 7, as the volume content $\phi$ of epsilon iron oxide increases, the permeability imaginary part

μ" (reference numeral 62) becomes larger, and the tan δ (reference numeral 63) also becomes larger. This confirms that electric waves can be absorbed more efficiently as the volume content ϕ of epsilon iron oxide occupied in the electric-wave absorbing layer increases. However, the larger volume content of epsilon iron oxide in the electric-wave absorbing layer results in the smaller ratio of the binder in the electric-wave absorbing layer. When the volume content of epsilon iron oxide exceeds a certain level, the electric-wave absorbing layer becomes fragile and cannot maintain its shape as a sheet.

As a result of studies by the present inventors, it was found that the volume content of epsilon iron oxide is preferably 30% or more, in order to realize the reflection attenuation rate RL of -15 dB or more (electric-wave absorption degree) and an electric-wave absorption percentage of 90% or more. From the viewpoint of the electric-wave absorption performance, the volume content of epsilon iron oxide is preferably 40% or more, and more preferably 50% or more.

The electric-wave absorbing layer of this embodiment is formed by preparing a magnetic coating material, and applying the magnetic coating material, followed by drying and calendering as described above. In this case, when the volume content of magnetic oxide in the composition in the preparation of the magnetic coating material was 63.8%, the percentage of voids in the applied and dried state before calendering was about 27.5%, and the volume content of the actual magnetic iron oxide including voids as the electric-wave absorbing layer was 46.3%. By performing calendering under the above production conditions in this state, the percentage of voids became 18.6%, and the volume content of the actual magnetic iron oxide including voids became 51.9%. Thus, when the volume content of the magnetic iron oxide considering voids exceeds 50%, it is possible to form an electric-wave absorbing layer that has a very high electric-wave absorption degree by magnetic resonance.

In a practical level, it is preferred that the electric-wave absorbing sheet has an electric-wave absorption rate of -10 dB or more. If the volume content of the magnetic oxide is 30% or more, it is possible to provide an electric-wave absorbing sheet having a practical electric-wave absorption rate reliably. If a binder made of a general material is used, and the volume content of the magnetic iron oxide exceeds 80%, flexibility as an electric-wave absorbing sheet cannot be obtained.

In view of the above, the volume content of the magnetic oxide in the electric-wave absorbing layer is preferably 30% or more, and the upper limit is about 80%. Moreover, the volume content of the magnetic oxide in the electric-wave absorbing layer is more preferably 50% or more.

The method for forming the electric-wave absorbing layer is not limited to the method using a solvent described above, and may be a method in which an electric-wave absorbing material is dispersed and blended in a binder without using a solvent. In this case, it is considered that since the voids of the electric-wave absorbing layer are reduced as compared with the electric-wave absorbing layer produced using a solvent, favorable electric-wave absorbing properties can be obtained even when the volume content of the electric-wave absorbing material in the electric-wave absorbing layer is low.

As described above, the electric-wave absorbing sheet of this embodiment contains, as the electric-wave absorbing material, epsilon iron oxide that magnetically resonates at a high frequency band equal to or higher than the millimeter-wave band, thereby absorbing electric waves in the frequency bands from the millimeter-wave band to one terahertz.

In the above embodiment, epsilon iron oxide is used as the electric-wave absorbing material in the electric-wave absorbing layer. By using epsilon iron oxide as described above, it is possible to form an electric-wave absorbing sheet that absorbs electric waves of 30 GHz to 300 GHz (millimeter-wave band). Further, by using rhodium or the like as a metal material substituting for the Fe site, it is possible to obtain an electric-wave absorbing sheet that absorbs electric waves of one terahertz, which is the highest frequency defined as electric wave.

In the electric-wave absorbing sheet disclosed in the present application, the magnetic iron oxide used as the electric-wave absorbing material of the electric-wave absorbing layer is not limited to epsilon iron oxide.

Hexagonal ferrite as a ferrite electromagnetic absorber exhibits electric-wave absorbing properties in the 76 GHz band, and strontium ferrite exhibits electric-wave absorbing properties in several tens of GHz band. By forming an electric-wave absorbing layer using magnetic iron oxide particles other than epsilon iron oxide having electric-wave absorbing properties in the millimeter-wave band from 30 GHz to 300 GHz and a resin binder, it is possible to obtain an electric-wave absorbing sheet that absorbs electric waves in the millimeter-wave band.

For example, hexagonal ferrite particles have a larger average particle diameter (about a dozen μm) than epsilon iron oxide particles exemplified in the above embodiment, and the shape of the hexagonal ferrite particles is not substantially spherical but plate or needle crystal. Because of this, in the formation of the magnetic coating material using a resin binder, it is preferable to adjust the use of a dispersant and the kneading conditions with the binder so that, when the magnetic coating material is applied, the magnetic iron oxide powder is dispersed as uniformly as possible in the electric-wave absorbing layer and the percentage of voids is as low as possible.

The above description explains, as a method for forming the electric-wave absorbing layer, the method that includes preparing a magnetic coating material, and applying and drying the magnetic coating material. Other than the method for applying the magnetic coating material described above, the production method of the electric-wave absorbing sheet disclosed in the present application may be, e.g., an extrusion molding method.

More specifically, magnetic iron oxide powder, a binder, and as needed a dispersant and the like are blended in advance, and the blended materials are supplied from a resin supply port of an extrusion molding machine into a plasticizing cylinder. The extrusion molding machine may be an ordinary extrusion molding machine that includes a plasticizing cylinder, a die provided at the tip of the plasticizing cylinder, a screw rotatably disposed in the plasticizing cylinder, and a driving mechanism that drives the screw. The material molten by a band heater of the extrusion molding machine is fed forward by the rotation of the screw and extruded into a sheet shape from the tip. The extruded material is subjected to drying, pressure molding, calendering, and the like to obtain an electric-wave absorbing layer having a predetermined thickness.

In the above embodiment, although the electric-wave absorbing layer of the electric-wave absorbing sheet is constituted by a single layer, it may be constituted by a plurality of layers stacked. The electric-wave absorbing properties of the electric-wave absorbing sheet of this embodiment can improve further by adjusting the thickness of the electric-wave absorbing layer to match the impedance of the electric-wave absorbing layer to the impedance in the air as described above. In case an electric-wave absorbing layer having a predetermined thickness cannot be constituted by a single layer due to the properties of the electric-wave absorbing material and binder that form the electric-wave absorbing layer, it is effective to form an electric-wave absorbing layer as a stack.

Industrial Applicability

The electric-wave absorbing sheet disclosed in the present application is useful as an electric-wave absorbing sheet that absorbs electric waves in a high frequency band equal to or higher than the millimeter-wave band.

Description of Reference Numerals

1    Electric-wave absorbing layer
1a   Epsilon iron oxide (electric-wave absorbing material)
1b   Binder
2    Reflective layer
3    Base film (base)
4    Adhesive layer

**Claims**

1. An electric-wave absorbing sheet comprising a flexible electric-wave absorbing layer comprising a particulate electric-wave absorbing material and a resin binder,
   wherein the electric-wave absorbing material is a magnetic iron oxide that magnetically resonates at a frequency band equal to or higher than a millimeter-wave band.

2. The electric-wave absorbing sheet according to claim 1, wherein the electric-wave absorbing layer comprises a dispersant for dispersing the electric-wave absorbing material.

3. The electric-wave absorbing sheet according to claim 2, wherein the dispersant is a phosphate compound.

4. The electric-wave absorbing sheet according to any one of claims 1 to 3, wherein the electric-wave absorbing material is epsilon iron oxide.

5. The electric-wave absorbing sheet according to claim 4, wherein part of a Fe site of the epsilon iron oxide is substituted with a trivalent metal atom.

6. The electric-wave absorbing sheet according to any one of claims 1 to 5, wherein a volume content of the magnetic iron oxide in the electric-wave absorbing layer is 30% or more.

7. The electric-wave absorbing sheet according to any one of claims 1 to 6, wherein the resin binder comprises at least either of a sulfonic group and a carboxyl group, and is halogen free.

8. The electric-wave absorbing sheet according to any one of claims 1 to 7, wherein the electric-wave absorbing layer has a thickness of 1 mm or less.

9. The electric-wave absorbing sheet according to any one of claims 1 to 8, wherein a reflective layer made of a metal plate, a metal foil or a metal-deposited film, is formed in contact with one surface of the electric-wave absorbing layer.

10. The electric-wave absorbing sheet according to any one of claims 1 to 9,
wherein the reflective layer and the electric-wave absorbing layer are stacked sequentially on a resin base, and an adhesive layer is formed on a surface of the resin base on a side opposite to a side where the electric-wave absorbing layer is disposed.

FIG. 1

FIG. 2

FIG. 3

FIG. 4

21

Vector network analyzer

Port1          Port2

11

12

22

23

3

1  2

FIG. 5

FIG. 6

FIG. 7

Magnetic material
$\mu_r = \mu_{rB}$

Resin
$\mu_r = 1$

FIG. 8

## INTERNATIONAL SEARCH REPORT

| International application No. |
|---|
| PCT/JP2017/022912 |

| A. CLASSIFICATION OF SUBJECT MATTER |
|---|
| *H05K9/00*(2006.01)i, *B32B15/08*(2006.01)i, *H01F1/34*(2006.01)i |

According to International Patent Classification (IPC) or to both national classification and IPC

| B. FIELDS SEARCHED |
|---|

Minimum documentation searched (classification system followed by classification symbols)
H05K9/00, B32B15/08, H01F1/34

Documentation searched other than minimum documentation to the extent that such documents are included in the fields searched
Jitsuyo Shinan Koho        1922–1996    Jitsuyo Shinan Toroku Koho    1996–2017
Kokai Jitsuyo Shinan Koho   1971–2017    Toroku Jitsuyo Shinan Koho    1994–2017

Electronic data base consulted during the international search (name of data base and, where practicable, search terms used)

| C. DOCUMENTS CONSIDERED TO BE RELEVANT |
|---|

| Category* | Citation of document, with indication, where appropriate, of the relevant passages | Relevant to claim No. |
|---|---|---|
| X<br>Y | JP 2016-111341 A  (The University of Tokyo),<br>20 June 2016 (20.06.2016),<br>paragraphs [0013] to [0030], [0051], [0059] to [0068]<br>& US 2016/0164187 A1<br>paragraphs [0021] to [0042], [0072], [0081] to [0090]<br>& EP 3029771 A1        & KR 10-2016-0067051 A | 1-2,4-6,8-9<br>3,7,10 |
| Y | JP 2007-193323 A  (Fujifilm Corp.),<br>02 August 2007 (02.08.2007),<br>paragraph [0050]<br>& WO 2007/073007 A1      & TW 200732691 A | 3 |

☒  Further documents are listed in the continuation of Box C.          ☐  See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search<br>    14 September 2017 (14.09.17) | Date of mailing of the international search report<br>    26 September 2017 (26.09.17) |
|---|---|
| Name and mailing address of the ISA/<br>    Japan Patent Office<br>    3-4-3,Kasumigaseki,Chiyoda-ku,<br>    Tokyo 100-8915,Japan | Authorized officer<br><br>Telephone No. |

Form PCT/ISA/210 (second sheet) (January 2015)

**INTERNATIONAL SEARCH REPORT**

| International application No. |
| --- |
| PCT/JP2017/022912 |

C (Continuation).   DOCUMENTS CONSIDERED TO BE RELEVANT

| Category* | Citation of document, with indication, where appropriate, of the relevant passages | Relevant to claim No. |
| --- | --- | --- |
| Y | JP 2012-071596 A  (Nippon Steel Corp.),<br>12 April 2012 (12.04.2012),<br>paragraphs [0044] to [0045], [0076] to [0079]<br>(Family: none) | 7 |
| Y | JP 2009-059752 A  (Hitachi Chemical Co., Ltd.),<br>19 March 2009 (19.03.2009),<br>abstract<br>(Family: none) | 7 |
| Y | JP 2011-181679 A  (TDK Corp.),<br>15 September 2011 (15.09.2011),<br>paragraphs [0003] to [0004]<br>(Family: none) | 7 |
| Y | JP 2006-332260 A  (Hajime MURAZAKI),<br>07 December 2006 (07.12.2006),<br>paragraphs [0011] to [0016]; fig. 1<br>(Family: none) | 10 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2011233834 A
- JP 2006080352 A
- JP 2015198163 A
- JP 2008060484 A
- JP 502 A